# EUROPEAN PATENT APPLICATION

(11) **EP 2 733 501 A2**
(43) Date of publication of application: **21.05.2014**
(21) Application number: 13193189.1
(22) Date of filing: 15.11.2013
(51) Int. Cl.: G01R 35/00, G01R 15/18

(54) **Systems and methods for monitoring current values**

(30) Priority: 19.11.2012 US 201213681345
(71) Applicant: General Electric Company, Schenectady, New York 12345 (US)
(72) Inventor: Pearson, William R., Schenectady, NY New York 12345 (US)
(74) Representative: Illingworth-Law, William Illingworth

(57) **Abstract**

A current monitoring system is provided. The current monitoring system includes a plurality of transformer assemblies 200 that are configured to generate a plurality of signals representative of current values. A computing device is coupled to the transformer assemblies 200. The computing device 206 includes a processor that is programmed to analyze the signals to verify the accuracy of the current values associated with the signals. The processor is also programmed to select at least one verified pair of signals from the signals to calculate at least one value for at least one control variable.

## Description

### BACKGROUND OF THE INVENTION

The field of the invention relates generally to power systems and, more particularly, to systems and methods for monitoring current being produced by the power system.

At least some known systems, such as power systems, use at least one turbine engine that is coupled to a load, such as an electrical generator. The turbine engine generates mechanical rotational energy and the generator converts the mechanical energy to electrical energy. At least some known monitoring or measurement systems may be used to monitor the current being generated by the generator. Any anomalies with the current levels detected by the monitoring system may be corrected with, for example, a generator control system.

Moreover, at least some known monitoring systems use at least one current transformer assembly that may be coupled to the generator, for example. Known transformer assemblies include a current transformer and a sensor that detects the current being generated. The transformer assembly generates signals that are representative of a current value, and the signals are transmitted to a computing device that determines the presence of any anomalies in the detected current levels. If anomalies are detected, the computing device may transmit a signal to the generator control system to apply any necessary control parameters. However, in some circumstances, the transformer assembly may be unable to operate. For example, in some circumstances, wiring issues or problems may develop within the sensor. As a result, the monitoring system may be unable to verify the accuracy of the current levels being generated and erroneous parameters may be implemented by the generator control system.

### BRIEF DESCRIPTION OF THE INVENTION

In one embodiment, a current monitoring system is provided. The current monitoring system includes a plurality of transformer assemblies that are configured to generate a plurality of signals representative of current values. A computing device is coupled to the transformer assemblies. The computing device includes a processor that is programmed to analyze the signals to verify the accuracy of the current values associated with the signals. The processor is also programmed to select at least one verified pair of signals from the signals to calculate at least one value for at least one control variable.

In another embodiment, a power system is provided. The power system includes at least one generator and a current monitoring system that is coupled to the generator. The current monitoring system includes a plurality of transformer assemblies that are configured to generate a plurality of signals representative of current values being produced by the generator. A computing device is coupled to the transformer assemblies. The computing device includes a processor that is programmed to analyze the signals to verify the accuracy of the current values associated with the signals. The processor is also programmed to select at least one verified pair of signals from the signals to calculate at least one value for at least one control variable.

In yet another embodiment, a method for monitoring current values is provided. A plurality of signals that are representative of current values are generated via a plurality of transformer assemblies. The signals are transmitted to a computing device coupled to the transformer assemblies, wherein the computing device includes a processor. The signals are analyzed, via the processor, to verify the accuracy of the current values associated with the signals. At least one verified pair of signals is selected from the signals to calculate at least one value for at least one control variable.

### BRIEF DESCRIPTION OF THE DRAWINGS

FIG. 1 is a block diagram of an exemplary power system; and
FIG. 2 is a block diagram of an exemplary monitoring system that may be used with the power system shown in Fig. 1 and taken from area 2.

### DETAILED DESCRIPTION OF THE INVENTION

The exemplary systems and methods described herein provide a monitoring system that may be used with power systems, for example, to verify the accuracy of current levels being produced by the power system. More specifically, the monitoring system described herein includes at least three transformer assemblies that are configured to detect current values. The monitoring system also includes a computing device that receives signals representative of the detected current values from the transformer assemblies. The computing device analyzes pairs of the signals to verify the accuracy of the current values associated with the signals. At least one verified pair of signals is selected for use in calculating at least one value for at least one control variable. By using detected current values from at least three transformer assemblies, and by being able to analyze the signals in pairs, the computing device can verify the accuracy of each of the current values. Moreover, even if one of the transformer assemblies is inoperable, the monitoring system is still operable using the detected current values from the other transformer assemblies.

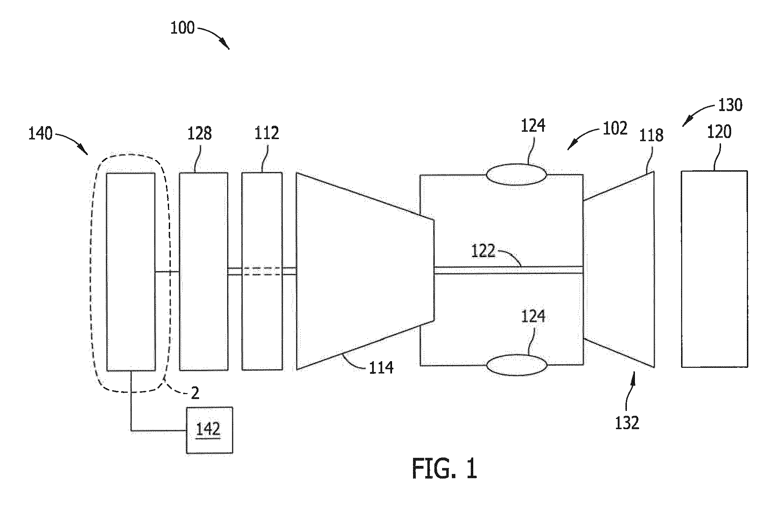

FIG. 1 illustrates a portion of an exemplary power system 100. Although the exemplary embodiment illustrates a power system, the present disclosure is not limited to power systems, and one of ordinary skill in the art will appreciate that the current disclosure may be used in connection with any type of system. In the exemplary embodiment, power system 100 includes a turbine engine 102. More specifically, in the exemplary embodiment, turbine engine 102 is a gas turbine engine. While the exemplary embodiment includes a gas turbine engine, the present invention is not limited to any one particular engine, and one of ordinary skill in the art will appreciate that the current disclosure may be used in connection with other turbine engines.

Moreover, in the exemplary embodiment, turbine engine 102 includes an intake section 112, a compressor section 114 coupled downstream from intake section 112, a combustor section 116 coupled downstream from compressor section 114, a turbine section 118 coupled downstream from combustor section 116, and an exhaust section 120. It should be noted that, as used herein, the term "couple" is not limited to a direct mechanical, thermal, communication, and/or an electrical connection between components, but may also include an indirect mechanical, thermal, communication and/or electrical connection between multiple components.

Turbine section 118, in the exemplary embodiment, is coupled to compressor section 114 via a rotor shaft 122. In the exemplary embodiment, combustor section 116 includes a plurality of combustors 124. Combustor section 116 is coupled to compressor section 114 such that each combustor 124 is positioned in flow communication with the compressor section 114. Turbine section 118 is coupled to compressor section 114 and to at least one load 128. In the exemplary embodiment, load 128 may be an electrical generator and/or a mechanical drive application that is coupled to an excitation system (not shown). In the exemplary embodiment, each compressor section 114 and turbine section 118 includes at least one rotor disk assembly 130 that is coupled to a rotor shaft 122 to form a rotor assembly 132.

Moreover, in the exemplary embodiment, a monitoring system 140 is coupled turbine engine 102. More specifically, in the exemplary embodiment, monitoring system 140 is coupled to the excitation system and/or to load 128. Power system 100 also includes a control system 142 coupled to monitoring system 140. Control system 142 may also include a controller (not shown) coupled to any other component(s) of power system 100, such as to load 128.

During operation, intake section 112 channels air towards compressor section 114 wherein the air is compressed to a higher pressure and temperature prior to being discharged towards combustor section 116. The compressed air is mixed with fuel and other fluids that are provided by each fuel injection assembly 126 and ignited to generate combustion gases that are channeled towards turbine section 118. More specifically, each fuel injection assembly 126 injects fuel, such as natural gas and/or fuel oil, air, diluents, and/or Nitrogen gas (N₂) in respective combustors 124, and into the air flow. The blended mixtures are ignited to generate high temperature combustion gases that are channeled towards turbine section 118. Turbine section 118 converts the thermal energy from the gas stream to mechanical rotational energy, as the combustion gases impart rotational energy to turbine section 118 and to rotor assembly 132. The mechanical rotational energy is converted to electrical energy via load 128.

As described in more detail below, monitoring system 140 detects the current values being generated by load 128. Moreover, monitoring system 140 verifies the accuracy of the current values and uses at least two of the verified current values to determine at least one control variable. More specifically, monitoring system 140 uses at least two of the verified current values to calculate at least one value for at least one control variable. For example, an output of the verified current values may be presented to a user and the user can then input various control parameters to control system 142. Control system 142 may use the controller to implement control parameters within power system 100. Alternatively, a signal representative of the control variable value may be transmitted from monitoring system 140 to control system 142 such that control system 142 may implement control parameters within power system 100 in response to the signal received.

Moreover, as described in more detail below, by verifying the current values, monitoring system 140 can also identify any outlier values and generate an output representative of the outlier values to enable any anomalies within power system 100 to be identified. Various control parameters can be input to control system 142 to correct any identified anomalies. Control system 142 may use the controller to implement control parameters within power system 100. Alternatively, a signal representative of a control variable based on the outlier values may be transmitted from monitoring system 140 to control system 142 to enable control system 142 to implement control parameters within power system 100 in response to the signals received.

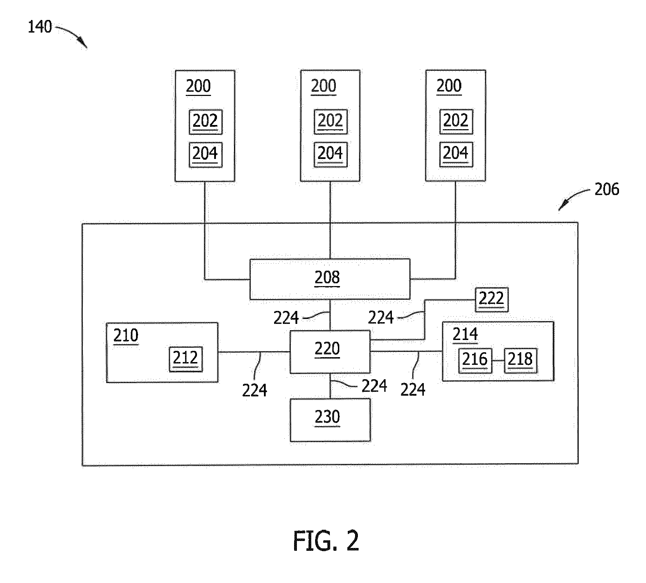

FIG. 2 is a block diagram of monitoring system 140. In the exemplary embodiment, monitoring system 140 includes a plurality of current transformer assemblies 200 that are each coupled to load 128 (shown in FIG. 1). More specifically, in the exemplary embodiment, three transformer assemblies 200 are coupled to load 128. While three transformer assemblies 200 are coupled to load 128 in the exemplary embodiment, monitoring system 140 may include any number of transformer assemblies 200 so long as there is at least one pair of assemblies 200.

In the exemplary embodiment, each transformer assembly 200 includes a current transformer 202 and a sensor 204 coupled to current transformer 202. More specifically, each current transformer 202 is coupled to load 128 and configured to channel currents received from load 128 to sensor 204. Monitoring system 140 also includes a computing device 206 that is coupled to each sensor 204. Each sensor 204 is configured to detect the currents being channeled from respective current transformer 202 and to transmit signals representative of the detected current values to computing device 206. More specifically, computing device 206 includes a sensor interface 208 that is configured to receive the signals. Each sensor 204 may transmit a signal continuously, periodically, or only once, for example. Other signal timings may also be contemplated. Furthermore, each sensor 204 may transmit a signal either in an analog form or in a digital form. Various connections that are known in the art may be available between sensor interface 208 and sensors 204.

In the exemplary embodiment, computing device 206 includes a user interface 210 that receives input from a user, such as, but not limited to an operator of power system 100. In the exemplary embodiment, user interface 210 includes a keyboard 212 that enables the user to input pertinent information.

Moreover, in the exemplary embodiment, computing device 206 includes a presentation interface 214 that presents information, such as, but not limited to input events and/or validation results, to the user. In the exemplary embodiment, presentation interface 214 includes a display adapter 216 that is coupled to at least one display device 218. More specifically, in the exemplary embodiment, display device 218 may be a visual display device known in the art.

Computing device 206 also includes a processor 220 and a memory device 222. In the exemplary embodiment, processor 220 is coupled to user interface 210, presentation interface 214, and to memory device 222 via a system bus 224. In the exemplary embodiment, processor 220 communicates with the user, such as, but not limited to by prompting the user via presentation interface 214 and/or by receiving user inputs via user interface 210. Moreover, in the exemplary embodiment, processor 220 is programmed by encoding an operation using one or more executable instructions and providing the executable instructions in memory device 222. For example, processor 220 may be programmed to analyze the signals received from sensors 204 of the detected current values in order to verify the accuracy of the detected current values. More specifically, in one embodiment, processor 220 may be programmed to analyze the signals by performing a magnitude calculation on at least one pair of signals, wherein each signal within the pair of signals is received from a different transformer assembly 200. Processor 220 may also be programmed to calculate a continuous standard deviation on the result of the magnitude calculation. Processor 220 may also be programmed to determine whether the standard deviation between the two current values associated with the pair of signals is substantially low and/or is below a predefined threshold. Processor 220 may further be programmed to identify any outlier signals. Processor 220 may generate at least one output, such as a textual or a graphical output of the signals, such that the output can be presented to a user via presentation interface 214 for failure analysis.

The term "processor" refers generally to any programmable system including systems and microcontrollers, reduced instruction set circuits (RISC), application specific integrated circuits (ASIC), programmable logic circuits (PLC), and any other circuit or processor capable of executing the functions described herein. The above examples are exemplary only, and thus are not intended to limit in any way the definition and/or meaning of the term "processor."

In the exemplary embodiment, memory device 222 includes one or more devices that enable information, such as, but not limited to executable instructions and/or other data, to be stored and retrieved. Moreover, in the exemplary embodiment, memory device 222 includes one or more computer readable media, such as, without limitation, dynamic random access memory (DRAM), static random access memory (SRAM), a solid state disk, and/or a hard disk. In the exemplary embodiment, memory device 222 stores, without limitation, application source code, application object code, configuration data, additional input events, application states, assertion statements, validation results, and/or any other type of data. More specifically, in the exemplary embodiment, memory device 222 stores input data received by a user via user interface 210, and/or information received from other components of power system 100, such as, but not limited to from sensors 204.

Computing device 206, in the exemplary embodiment, also includes a communication interface 230 that is coupled to processor 220 via system bus 224. Moreover, in the exemplary embodiment, communication interface 230 is communicatively coupled to control system 142 (shown in FIG. 1) such that communication interface 230 can communicate with control system 142, and/or other components within power system 100. Various connections that are known in the art may be available between communication interface 230 and control system 142..

During operation, turbine engine 102 (shown in FIG. 1) generates mechanical rotational energy that is converted to electrical energy via load 128. Monitoring system 140 detects the current values being generated by load 128. More specifically, in the exemplary embodiment, electrical currents are channeled from load 128 to each current transformer 202. Sensors 204 detect the current values that are channeled to each respective transformer 202. Each sensor 204 generates a signal representative of the detected current values, and each sensor 204 transmits the generated signal to computing device 206.

Computing device 206 analyzes the signals to verify the accuracy of the detected current values. In the exemplary embodiment, processor 220 performs a magnitude calculation on at least one pair of signals received from transformer assemblies 200. More specifically, in one embodiment, processor 220 may receive one signal representative of a detected current value from each transformer assembly 200, wherein a signal from one transformer assembly 200 is designated as "a", a signal from a second transformer assembly 200 is designated as "b", and a signal from a third transformer assembly 200 is designated as "c". Processor 220 designates the signals in pairs designated as Iab, Ibc, and Ica. Each of the current pairs of signals is converted to a quadrature based signal set, referred to as (α,β). The phasing of each (α,β) set is the same as any other set. Processor 220 uses each (α,β) set to calculate a corresponding magnitude signal, referred to as V.MagIaIb V.MagIbIc, and V.MagIaIc. In the exemplary embodiment, each magnitude signal is a direct current (DC) signal without significant alternating current (AC) content. Accordingly, if a failure exists for any of the transformer assemblies 200, there will be a significant AC content in two of the magnitude signals. Alternatively, the magnitude signals may be any type of signal that enables current monitoring system 140 and/or power system 100 to function as described herein.

Moreover, in the exemplary embodiment, processor 220 may calculate a continuous standard deviation on the results of the aforementioned magnitude signal calculations. The signal pair with the lowest standard deviation is presumed accurate and this pair is used as an active pair. More specifically, this signal pair is deemed verified as substantially accurate and processor 220 selects the verified or active pair to calculate at least one value for at least one control variable. For example, since any pair can be used in a non-failure condition, a control parameter, such as P.IabcPairHys, may be used to prevent unnecessary pair switching. Current monitoring system 140 may work for either a forward or reverse phase sequence. Additional features supporting the aforementioned operations include P.IabcDefault, which allows selection of a default pair. The pair selected will become the active pair using a button command C.97. This feature may be used as a test aid. As an enumeration of the parameter, any pair can be made the active pair. In the event of a communications failure, a default pair may be selected. P.StdDevIabcTc may be the time constant used in each continuous standard deviation calculation.

Processor 220 may also identify any signals received from transformer assemblies 200 that are representative of outlier current values. For example, when processor 220 calculates a continuous standard deviation to identify a verified signal pair with the lowest standard deviation, processor 220 may also identify which signals have a substantially higher standard deviation compared with the verified signal pair. Processor 220 may also identify when signals show standard deviation calculation levels that are above a predefined threshold. In one embodiment, standard deviation calculation levels above the predefined threshold may indicate a failed or a defective transformer assembly 200. If only one or all three show a high standard deviation calculation level, there may be a generic diagnostic since an exact device failure cannot be determined.

Processor 220 may generate an output, such as a graphical and/or a textual output of the results of the above-referenced calculations, such that the output can be presented to a user via presentation interface 214. For example, a graphical output of the standard deviation calculations may be presented to the user and/or the verified current values may be presented to the user. The user can use such information to initiate repairs. For example, the user can then input various control parameters to control system 142. Control system 142 may use a controller (not shown) to implement control parameters within power system 100. Additionally, a signal representative of the control variable value may be transmitted from monitoring system 140 to control system 142 such that control system 142 may implement control parameters within power system 100 in response to the signal received.

As compared to known monitoring systems used with power systems, the monitoring system described herein is able to verify the accuracy of current levels being produced by the power system. More specifically, the monitoring system includes using at least three transformer assemblies that detect current values, and a computing device that receives signals that are representative of the detected current values from the transformer assemblies. The signals are analyzed in pairs to verify the accuracy of the current values associated with the signals. At least one verified pair of signals is selected to calculate at least one value for at least one control variable. By using detected current values from at least three transformer assemblies and by being able to analyze the signals in pairs, the computing device is enabled to verify the accuracy of each of the current values. Moreover, even if one of the transformer assemblies is inoperable, the monitoring system would still be able to use the detected current values from the other transformer assemblies for control purposes; thus, enabling correct operation notwithstanding a failure.

A technical effect of the systems and methods described herein includes at least one of: (a) generating a plurality of signals that are representative of current values via a plurality of transformer assemblies; (b) transmitting a plurality of signals to a computing device coupled to a plurality of transformer assemblies, wherein the computing device includes a processor; (c) analyzing, via a processor, a plurality of signals to verify the accuracy of current values associated with the plurality of signals; and (d) selecting, via a processor, at least one verified pair of signals from a plurality of signals to calculate at least one value for at least one control variable.

Exemplary embodiments of the systems and methods are described above in detail. The systems and methods are not limited to the specific embodiments described herein, but rather, components of the systems and/or steps of the methods may be utilized independently and separately from other components and/or steps described herein. For example, the systems may also be used in combination with other systems and methods, and is not limited to practice with only the systems as described herein. Rather, the exemplary embodiment can be implemented and utilized in connection with many other applications.

Although specific features of various embodiments of the invention may be shown in some drawings and not in others, this is for convenience only. In accordance with the principles of the invention, any feature of a drawing may be referenced and/or claimed in combination with any feature of any other drawing.

This written description uses examples to disclose the invention, including the best mode, and also to enable any person skilled in the art to practice the invention, including making and using any devices or systems and performing any incorporated methods. The patentable scope of the invention is defined by the claims, and may include other examples that occur to those skilled in the art. Such other examples are intended to be within the scope of the claims if they have structural elements that do not differ from the literal language of the claims, or if they include equivalent structural elements with insubstantial differences from the literal language of the claims.

Various aspects and embodiments of the present invention are defined by the following numbered clauses:
1. A current monitoring system comprising:
   a plurality of transformer assemblies configured to generate a plurality of signals representative of current values; and
   a computing device coupled to said plurality of transformer assemblies, said computing device comprising a processor programmed to:
      analyze the plurality of signals to verify the accuracy of the current values associated with the plurality of signals; and
      select at least one verified pair of signals from the plurality of signals to calculate at least one value for at least one control variable.
2. A current monitoring system in accordance with Clause 1, wherein said processor is programmed to analyze the plurality of signals by performing a magnitude calculation on at least one pair of signals of the plurality of signals and by calculating a continuous standard deviation on the result of the magnitude calculation.
3. A current monitoring system in accordance with Clause 1 or Clause 2, wherein said processor is further programmed to identify at least one signal of the plurality of signals that is representative of an outlier current value.
4. A current monitoring system in accordance with any preceding Clause, wherein said computing device further comprises a presentation interface configured to display at least one output of the outlier current value to enable a user to identify whether one of said plurality of transformer assemblies is inoperable.
5. A current monitoring system in accordance with any preceding Clause, wherein said computing device comprises a communication interface coupled to said processor, said communication interface is configured to transmit at least one output to a controller that generates control parameters based on the at least one value.
6. A current monitoring system in accordance with any preceding Clause, wherein said plurality of transformer assemblies comprise a first transformer assembly configured to generate a first signal representative of a first current value, a second transformer assembly configured to generate a second signal representative of a second current value, and a third transformer assembly configured to generate a third signal representative of a third current value.
7. A current monitoring system in accordance with any preceding Clause, wherein said processor is programmed to analyze the first, second, and third signals to verify the accuracy of the first, second, and third current values, respectively, said processor is further programmed to select at least two of the first, second, and third signals that have been verified to calculate the at least one value for the at least one control variable.
8. A power system comprising:
   at least one generator; and
   a current monitoring system coupled to said at least one generator, said current monitoring system comprising:
      a plurality of transformer assemblies configured to generate a plurality of signals representative of current values being produced by said at least one generator; and
      a computing device coupled to said plurality of transformer assemblies, said computing device comprising a processor programmed to analyze the plurality of signals to verify the accuracy of the current values associated with the plurality of signals and to select at least one verified pair of signals from the plurality of signals to calculate at least one value for at least one control variable.
9. A power system in accordance with any preceding Clause, wherein said processor is programmed to analyze the plurality of signals by performing a magnitude calculation on at least one pair of signals of the plurality of signals and by calculating a continuous standard deviation on the result of the magnitude calculation.
10. A power system in accordance with any preceding Clause, wherein said processor is further programmed to identify at least one signal of the plurality of signals that is representative of an outlier current value.
11. A power system in accordance with any preceding Clause, wherein said computing device further comprises a presentation interface configured to display at least one output of the outlier current value to enable a user to identify whether one of said plurality of transformer assemblies is inoperable.
12. A power system in accordance with any preceding Clause, further comprising a controller coupled to said computing device, wherein said controller is configured to generate control parameters based on the at least one value.
13. A power system in accordance with any preceding Clause, wherein said plurality of transformer assemblies comprise a first transformer assembly configured to generate a first signal representative of a first current value, a second transformer assembly configured to generate a second signal representative of a second current value, and a third transformer assembly configured to generate a third signal representative of a third current value.
14. A power system in accordance with any preceding Clause, wherein said processor is programmed to analyze the first, second, and third signals to verify the accuracy of the first, second, and third current values, respectively, said processor is further programmed to select at least two of the first, second, and third signals that have been verified to calculate the at least one value for the at least one control variable.
15. A method for monitoring current values, said method comprising:
   generating a plurality of signals that are representative of current values via a plurality of transformer assemblies;
   transmitting the plurality of signals to a computing device coupled to the plurality of transformer assemblies, wherein the computing device includes a processor;
   analyzing, via the processor, the plurality of signals to verify the accuracy of the current values associated with the plurality of signals; and
   selecting, via the processor, at least one verified pair of signals from the plurality of signals to calculate at least one value for at least one control variable.
16. A method in accordance with any preceding Clause, further comprising transmitting, via a communication interface, at least one output to a controller that is configured to generate control parameters based on the at least one value.
17. A method in accordance with any preceding Clause, further comprising identifying, via the processor, at least one signal of the plurality of signals that is representative of an outlier current value.
18. A method in accordance with any preceding Clause, further comprising generating, via the processor, at least one output of the outlier current value.
19. A method in accordance with any preceding Clause, further comprising displaying, via a presentation interface, the at least one output of the outlier current value to enable a user to identify whether one of the plurality of transformer assemblies is inoperable.
20. A method in accordance with any preceding Clause, wherein analyzing, via the processor, the plurality of signals further comprises:
   performing a magnitude calculation on at least one pair of signals of the plurality of signals; and
   calculating a continuous standard deviation on the result of the magnitude calculation.

## Claims

1. A current monitoring system comprising:
a plurality of transformer assemblies (200) configured to generate a plurality of signals representative of current values; and
a computing device (206) coupled to said plurality of transformer assemblies (200), said computing device comprising a processor programmed to:
analyze the plurality of signals to verify the accuracy of the current values associated with the plurality of signals; and
select at least one verified pair of signals from the plurality of signals to calculate at least one value for at least one control variable.

2. A current monitoring system in accordance with Claim 1, wherein said processor is programmed to analyze the plurality of signals by performing a magnitude calculation on at least one pair of signals of the plurality of signals and by calculating a continuous standard deviation on the result of the magnitude calculation.

3. A current monitoring system in accordance with Claim 1 or Claim 2, wherein said processor is further programmed to identify at least one signal of the plurality of signals that is representative of an outlier current value.

4. A current monitoring system in accordance with any preceding Claim, wherein said computing device further comprises a presentation interface configured to display at least one output of the outlier current value to enable a user to identify whether one of said plurality of transformer assemblies is inoperable.

5. A current monitoring system in accordance with any preceding Claim, wherein said computing device comprises a communication interface coupled to said processor, said communication interface is configured to transmit at least one output to a controller that generates control parameters based on the at least one value.

6. A current monitoring system in accordance with any preceding Claim, wherein said plurality of transformer assemblies comprise a first transformer assembly configured to generate a first signal representative of a first current value, a second transformer assembly configured to generate a second signal representative of a second current value, and a third transformer assembly configured to generate a third signal representative of a third current value.

7. A current monitoring system in accordance with any preceding Claim, wherein said processor is programmed to analyze the first, second, and third signals to verify the accuracy of the first, second, and third current values, respectively, said processor is further programmed to select at least two of the first, second, and third signals that have been verified to calculate the at least one value for the at least one control variable.

8. A power system comprising:
at least one generator; and
a current monitoring system according to any one of the preceding claims, coupled to said at least one generator;
wherein the plurality of transformer assemblies are configured to generate a plurality of signals representative of current values being produced by said at least one generator.

9. A power system in accordance with Claim 8, further comprising a controller coupled to said computing device, wherein said controller is configured to generate control parameters based on the at least one value.

10. A method for monitoring current values, said method comprising:
generating a plurality of signals that are representative of current values via a plurality of transformer assemblies;
transmitting the plurality of signals to a computing device coupled to the plurality of transformer assemblies, wherein the computing device includes a processor;
analyzing, via the processor, the plurality of signals to verify the accuracy of the current values associated with the plurality of signals; and
selecting, via the processor, at least one verified pair of signals from the plurality of signals to calculate at least one value for at least one control variable.

11. A method in accordance with Claim 10, further comprising transmitting, via a communication interface, at least one output to a controller that is configured to generate control parameters based on the at least one value.

12. A method in accordance with Claim 10 or Claim 11, further comprising identifying, via the processor, at least one signal of the plurality of signals that is representative of an outlier current value.

13. A method in accordance with any one of Claims 10 to 12, further comprising generating, via the processor, at least one output of the outlier current value.

14. A method in accordance with any one of Claims 10 to 13, further comprising displaying, via a presentation interface, the at least one output of the outlier current value to enable a user to identify whether one of the plurality of transformer assemblies is inoperable.

15. A method in accordance with any one of Claims 10 to 14, wherein analyzing, via the processor, the plurality of signals further comprises:
performing a magnitude calculation on at least one pair of signals of the plurality of signals; and
calculating a continuous standard deviation on the result of the magnitude calculation.
